# FASCICULE DE BREVET EUROPEEN

(11) **EP 3 207 541 B1**
(45) Date de publication et mention de la délivrance du brevet: **21.08.2019**
(21) Numéro de dépôt: 15794214.5
(22) Date de dépôt: 13.10.2015
(51) Int. Cl.: G09F 9/30, G02B 19/00, G02F 1/1335, G02B 5/30, H01L 31/054

(54) **MODULE PHOTOVOLTAÏQUE POLARISANT INTÉGRÉ DANS L'ÉCRAN D'UN DISPOSITIF ÉLECTRONIQUE D'AFFICHAGE**
IN DEN BILDSCHIRM EINER ELEKTRONISCHEN ANZEIGEVORRICHTUNG INTEGRIERTES POLARISIERENDES FOTOVOLTAIKMODUL
POLARISING PHOTOVOLTAIC MODULE BUILT INTO THE SCREEN OF AN ELECTRONIC DISPLAY DEVICE

(30) Priorité: 15.10.2014 FR 1402316
(43) Date de publication de la demande: 23.08.2017
(73) Titulaire: Sunpartner Technologies, 13090 Aix-en-Provence (FR)
(72) Inventeur: KERZABI, Badre, F-13090 Aix en Provence (FR); CHAPPAZ, Cyril, F-13090 Aix en Provence (FR)
(74) Mandataire: Nicolle, Olivier
(86) Numéro de dépôt international: PCT/FR2015/000195
(87) Numéro de publication internationale: WO 2016/059303

(56) Documents cités:
- WO-A2-2012/142168
- JP-A- H0 894 992
- JP-A- 2011 164 252
- US-A1- 2007 076 143
- KENICHIRO HIROSE ET AL: "Polarization-transmissive photovoltaic film device consisting of an Si photodiode wire-grid", JOURNAL OF OPTICS. A, PURE AND APPLIED OPTICS, INSTITUTE OF PHYSICS PUBLISHING, BRISTOL, GB, vol. 10, no. 4, 1 avril 2008 (2008-04-01), page 44014, XP020138031, ISSN: 1464-4258 cité dans la demande

## Description

### Domaine technique de l'invention

La présente invention concerne les écrans émissifs, réflectifs ou transflectifs faisant partie de dispositifs électroniques d'affichage contenant un ou plusieurs polariseurs et intégrant un module photovoltaïque semi-transparent.

### Etat de la technique

Dans la présente invention, on appelle un dispositif d'affichage un dispositif électronique muni d'un écran qui permet d'afficher une image ou un message lumineux par un guidage adéquat de la lumière générée par ledit dispositif (écrans émissifs) et/ou de la lumière ambiante (écrans réflectifs et transflectifs).

La plupart de ces écrans sont des écrans à cristaux liquides ou électroluminescents qui contiennent généralement un ou deux polariseurs. Les deux critères de performance d'un polariseur sont d'une part de maximiser la transmittance d'une première composante polarisée linéaire de la lumière incidente et d'autre part de maximiser le coefficient d'extinction, c'est-à-dire le rapport de transmittance entre la première composante polarisée linéaire et la seconde composante polarisée linéaire (orthogonale à la première). Ainsi, un polariseur sera idéalement le plus performant s'il laisse passer toute la première composante polarisée linéaire de la lumière incidente et bloque (par absorption ou réflexion) l'intégralité de la seconde composante polarisée linéaire.

Les polariseurs standards les plus utilisés dans les dispositifs d'affichage sont des polariseurs organiques, qui transmettent environ 85% d'une première composante polarisée linéaire et absorbent plus de 99% de la seconde. Pour accroître l'efficacité et pour réduire l'épaisseur desdits polariseurs organiques, d'autres types de polariseurs inorganiques ont vu le jour, appelés couramment « wire-grid polarizers » en anglais ou WGP par acronyme. Constitués d'une multitude de bandes métalliques réfléchissantes séparées par des orifices dont les largeurs sont inférieures aux longueurs d'ondes de la lumière visible, les WGP se distinguent des polariseurs organiques en ce qu'ils réfléchissent la seconde composante polarisée linéaire, d'où leur dénomination de polariseurs semi-réfléchissants ou transflectifs. Seul leur coût reste un frein à leur utilisation, mais des procédés de fabrication à rouleaux (plus communément appelés « roll-to-roll » en anglais) tendent à faire baisser leur prix.

La combinaison d'un polariseur transflectif avec un module photovoltaïque pleine plaque placé en dessous dudit polariseur permet de remplacer un des polariseurs standards ainsi que le réflecteur arrière utilisé dans de tels écrans, tout en produisant de l'énergie électrique. Néanmoins, dans un tel système, 50% de la lumière ambiante est perdue dans le premier polariseur, les 50% restants étant soit réfléchis soit transmis par le second polariseur transflectif en fonction de l'état, clair ou sombre, du pixel. Ainsi, seule 25% de la lumière ambiante en moyenne est convertie en électricité par le module photovoltaïque. De plus, en fonction de l'image affichée par l'écran, l'intensité lumineuse reçue par le module photovoltaïque n'est pas uniforme sur toute sa surface, ce qui pose problème dans le cas où ledit module photovoltaïque est constitué de cellules connectées en série. En effet, si l'une des cellules est sous un éclairage inférieur à celui des autres cellules, la baisse de production électrique de cette cellule va affecter toutes les autres cellules, car le courant électrique va être réduit de la même manière dans toutes les cellules connectées en série.

Une autre approche, compatible avec tous les types d'écrans précités, consiste à structurer directement à l'échelle nanométrique un matériau photovoltaïque sous la forme de « wire-grid » afin qu'il joue le rôle de polariseur tout en générant de l'énergie électrique par conversion de la composante polarisée linéaire de la lumière non transmise (publication Journal of Optics A: Pure and Applied Optics, 2008, vol.10, p.44014 - University of Tokyo). La fabrication d'une telle structure nécessite cependant la maîtrise de la gravure à l'échelle nanométrique via des procédés complexes et coûteux donc difficilement industrialisables. De plus, il y a un nécessaire compromis à trouver entre l'efficacité de la polarisation et l'efficacité de la conversion photovoltaïque, en jouant en particulier sur l'épaisseur des nanostructures fabriquées. Les performances atteintes à ce jour sont très faibles, avec une efficacité de conversion de 0.2% et un coefficient d'extinction d'environ 5, ce qui prouve le concept mais reste inacceptable pour une intégration dans un écran.

Une variante consiste à réaliser le polariseur et l'absorbeur photovoltaïque à partir de la structuration anisotrope d'un même mélange de matériaux organiques (brevet WO2012142168 et publication Advanced Materials, 2011, vol.23, p.4193 - University of California Los Angeles). Le principal avantage de cette variante est de récupérer intrinsèquement l'énergie lumineuse d'une des deux composantes polarisées linéaires de la lumière ambiante (celle qui est perdue par absorption dans les polariseurs organiques standards) pour générer de l'énergie électrique. Toutefois, pour être efficace, le matériau photovoltaïque organique absorbe au moins en partie le spectre de la lumière visible, ce qui donne un aspect coloré à ce module photovoltaïque polarisant et modifierait sensiblement la colorimétrie de l'écran dans lequel il serait intégré.

### Buts de l'invention

Le but principal de la présente invention est de proposer un module photovoltaïque polarisant apte à récupérer et utiliser l'énergie lumineuse de la composante polarisée linéaire absorbée par le polariseur pour la transformer en énergie électrique, tout en minimisant l'impact de l'intégration d'un tel module (polarisant et photovoltaïque) sur la qualité de l'image affichée par l'écran.

Un autre but de l'invention est de produire de l'énergie électrique indépendamment de l'état, clair ou sombre, des pixels.

### Objets de l'invention

L'objet de l'invention concerne un dispositif d'affichage, ainsi qu'un procédé de réalisation d'une partie du dispositif, ainsi qu'un appareil comportant un tel dispositif

Le dispositif d'affichage selon l'invention est pourvu d'un module photovoltaïque polarisant qui comporte au moins :
(a) un polariseur;
(b) une pluralité de pixels qui émettent ou transmettent une lumière appelée lumière de l'image ;
(c) une pluralité de zones actives photovoltaïques ;
ledit dispositif étant caractérisé en ce que deux zones actives photovoltaïques voisines forment un orifice, lesdites zones actives photovoltaïques étant disposées entre les pixels et le polariseur, et en ce que ledit polariseur est constitué d'une ou plusieurs surfaces choisies parmi des surfaces planes, concaves ou convexes, le polariseur présentant des formes paraboliques, coniques, pyramidales, tétraédriques, demi-cylindriques ou cylindro-paraboliques, et étant agencé de manière à d'une part concentrer par réflexion une première composante polarisée linéaire (P1) de la lumière ambiante sur lesdites zones actives photovoltaïques et à d'autre part transmettre à travers le module photovoltaïque polarisant une deuxième composante polarisée linéaire (P2) de la lumière ambiante ou de la lumière de l'image.

Ledit polariseur est sont composé d'un réseau de bandes réfléchissantes dont les largeurs et les distances qui les séparent sont avantageusement inférieures à 400 nanomètres. Les bandes réfléchissantes sont généralement parallèles entre elles et métalliques, par exemple en argent, en aluminium ou en cuivre. Elles peuvent également être constituées de plusieurs couches de métaux déposées successivement les unes sur les autres.

On définit un concentrateur de lumière comme un concentrateur optique apte à collecter la lumière d'un faisceau lumineux ayant différents angles d'incidence dans une zone de l'espace dite « surface d'entrée » pour la guider vers une surface plus petite dite « surface de sortie », et correspondant généralement au sommet du concentrateur. Le taux de concentration du concentrateur de lumière est alors défini comme le rapport de la surface de sortie sur la surface d'entrée.

Dans la présente invention, les concentrateurs de lumière semi-réfléchissants permettent de guider par réflexions multiples une première composante polarisée linéaire (P1) de la lumière ambiante vers les zones actives photovoltaïques, de manière à produire de l'énergie électrique. Ainsi, les sommets des concentrateurs doivent être positionnés en regard des zones actives du module photovoltaïque de telle sorte que l'essentiel de ladite première composante polarisée linéaire de la lumière ambiante focalisée par lesdits concentrateurs soit dirigée vers les zones actives photovoltaïques.

La pluralité des zones actives photovoltaïques peuvent former une cellule photovoltaïque unique ou un ensemble de cellules connectées électriquement en série ou en parallèle pour former un module photovoltaïque. Il peut également s'agir de plusieurs cellules ou modules indépendants. De manière générique on appelle par la suite « module photovoltaïque » l'une quelconque de ces configurations. Lesdites zones actives photovoltaïques peuvent être actives sur une ou plusieurs faces et sont constituées d'un ou plusieurs matériaux actifs qui peuvent être inorganiques ou organiques, cristallins ou amorphes, opaques ou semi-transparents. Ces matériaux actifs sont avantageusement des couches minces à base de silicium amorphe ou microcristallin, de GaAs (arséniure de gallium), de CdTe (tellurure de cadmium), de CIGS (cuivre - indium - gallium - sélénium), de CZTS (cuivre - zinc - étain - sélénium) ou à base de polymères. Il peut s'agir de jonctions de type p-i-n ou p-n, ou encore de cellules tandem, i.e. comportant deux cellules superposées qui absorbent préférentiellement une partie différente du spectre lumineux. Elles peuvent être conçues pour convertir la lumière visible et/ou la lumière ultra-violette et/ou la lumière infrarouge en électricité.

Selon un certain mode de réalisation du dispositif selon l'invention, lesdites zones actives photovoltaïques sont positionnées au voisinage du plan de concentration maximum desdits polariseurs. Cette configuration optimise la quantité de lumière ambiante dirigée sur les zones actives photovoltaïques, et permet ainsi de maximiser la production électrique du module. En pratique, la quantité de lumière concentrée sur les zones actives dépend notamment de l'angle d'incidence de la lumière ambiante à la surface des polariseurs, une partie de la lumière étant perdue par réflexion de la surface du concentrateur vers l'extérieur du dispositif. En effet, tous les concentrateurs ont un cône d'acceptance de la lumière incidente contraint, c'est-à-dire un angle d'incidence limite au-delà duquel la lumière incidente n'est plus focalisée mais renvoyée hors du système optique. Ce cône d'acceptance dépend de la forme des concentrateurs et est d'autant plus limité que le taux de concentration, c'est-à-dire le rapport de la surface du flux lumineux en entrée sur la surface du flux lumineux en sortie est important.

Selon un autre mode de réalisation, la pluralité de pixels sont séparés les uns des autres par une matrice interpixels et les zones actives photovoltaïques sont alignées avec ladite matrice interpixels de manière à réduire au maximum les phénomènes de Moiré, bien connus de l'homme du métier.

Selon une variante supplémentaire de réalisation du dispositif, les zones actives photovoltaïques et les polariseurs sont organisés en un réseau continu ou discontinu de motifs élémentaires, délimitant tous types de formes, en particulier des formes courbes, par exemple circulaires, des formes planes, par exemple polygonales, prismatiques ou hexagonales. Dans ce cas, on peut avantageusement choisir un pas du réseau de zones actives photovoltaïques qui soit adapté au pas de la matrice interpixels afin de réduire au maximum les phénomènes de Moiré.

Selon différents mode de réalisation, lesdits pixels peuvent être constitués de modulateurs électro-optiques, éventuellement associés à des filtres colorés, ou de matériaux électroluminescents. Les modulateurs électro-optiques permettent de faire varier la luminosité du pixel et les filtres colorés sont typiquement de couleurs rouge, vert et bleu (RGB) pour une technologie additive et cyan, magenta et jaune (CMJ) pour une technologie soustractive. La technologie RGB additive est couplée par exemple avec un modulateur à cristaux liquides dans des dispositifs d'affichage de type « Liquid Crystal Display », alors que la technologie CMJ soustractive est mise en oeuvre dans les dispositifs utilisant des modulateurs de type dit « electrowetting ».

Selon différents mode de réalisation, la lumière de l'image correspond à une partie de la lumière ambiante réfléchie, totalement ou partiellement, dans le dispositif et/ou une partie de la lumière émise par le dispositif. Dans le cas d'un dispositif d'affichage de type « Liquid Crystal Display » (LCD) émissif, la lumière émise par le dispositif peut être générée par une ou plusieurs diodes électroluminescentes (LED), généralement blanches, situées directement en regard du dispositif objet de l'invention, ou .bien sur le côté d'un guide d'ondes transparent dans lequel la lumière est propagée. Dans le cas d'un dispositif d'affichage de type OLED, la lumière émise est générée par une pluralité de sources électroluminescentes organiques qui émettent préférentiellement dans une partie du spectre du visible.

Selon différents modes de réalisation, le dispositif d'affichage comporte en outre un ou plusieurs autres polariseurs et/ou une lame quart d'onde servant à polariser la lumière de l'image. Ces polariseurs, par exemple de type organique ou de type « wire grid », sont intégrés dans les dispositifs de type LCD ou OLED connus. Le module du dispositif d'affichage selon l'invention comprenant les polariseurs et les zones actives photovoltaïques peut être laminé par-dessus le dernier polariseur et/ou la lame quart d'onde dudit dispositif. Alternativement, il peut remplacer le dernier polariseur de manière à faire l'économie d'une surface polarisante et à réduire l'épaisseur dudit dispositif d'affichage.

Dans un autre mode de réalisation particulier non représenté, le dispositif d'affichage comporte en outre une surface fonctionnelle, par exemple anti-reflet, anti-UV ou de détection tactile.

Le dispositif d'affichage selon l'invention peut être intégré dans un appareil électronique, fixe ou portable, rigide ou flexible, tel qu'une montre, un téléphone, une liseuse, une tablette, ou encore un ordinateur.

Selon un exemple de procédé de fabrication d'un module photovoltaïque polarisant pour un dispositif d'affichage selon l'invention, comportant un polariseur et des zones actives photovoltaïques, on procède de la manière suivante :
(a) on approvisionne un module photovoltaïque polarisant semi-transparent composé d'une pluralité de zones actives photovoltaïques et d'une pluralité d'orifices, lesdites zones actives photovoltaïques étant constituées d'une pluralité de couches minces déposées sur un substrat transparent ;
(b) on dépose une première couche de résine transparente puis on structure ladite résine de manière à former un polariseur de forme parabolique, conique, pyramidale, tétraédrique, demi-cylindrique ou cylindro-parabolique ;
(c) on dépose une couche conforme d'un matériau réfléchissant sur la face structurée de ladite résine ;
(d) on grave la couche réfléchissante sur toute sa surface sous la forme de bandes et au niveau des sommets du polariseur, les bandes étant agencées de manière à d'une part concentrer par réflexion une première composante polarisée linéaire (P1) de la lumière incidente sur lesdites zones actives photovoltaïques (1) et à d'autre part transmettre à travers ledit module photovoltaïque polarisant une deuxième composante polarisée linéaire (P2) orthogonale à la première. ;
(e) on dépose une seconde couche de résine transparente de planarisation.

Le substrat transparent du module photovoltaïque semi-transparent est généralement constitué d'un matériau transparent solide, comme le verre ou encore un polymère de type PMMA, PET ou polycarbonate, et a un indice de réfraction proche de 1.5. Avantageusement, l'indice de réfraction de la première couche de résine transparente est identique à celui du substrat transparent. Dans ce procédé de fabrication, la structuration de la première couche de résine transparente peut être réalisée sous irradiation UV, à l'aide de rouleaux ou de tampons texturés qui impriment un réseau de formes sur un polymère liquide ou semi-liquide photosensible, ou par emboutissage d'un matériau transparent solide. L'étape de gravure de la couche réfléchissante peut être réalisée par un procédé de photolithographie ou par laser. L'indice de la seconde couche de résine doit être optimisé en fonction de celui de la première couche de résine de manière à limiter les réflexions totales aux interfaces, mais également en fonction de la forme des concentrateurs de manière à maximiser l'angle d'acceptance de la lumière incidente.

### Figures

L'invention sera mieux comprise à l'aide de sa description détaillée, en relation avec les figures, dans lesquelles :
- les figures 1a et 1b montrent schématiquement des vues en coupe transversale d'une partie du dispositif d'affichage selon l'invention et illustrent son fonctionnement ;
- la figure 2 montre schématiquement en coupe transversale la structure d'un dispositif d'affichage de type LCD émissif selon l'invention ;
- la figure 3 montre schématiquement en coupe transversale la structure d'un dispositif d'affichage de type LCD réflectif selon l'invention ;

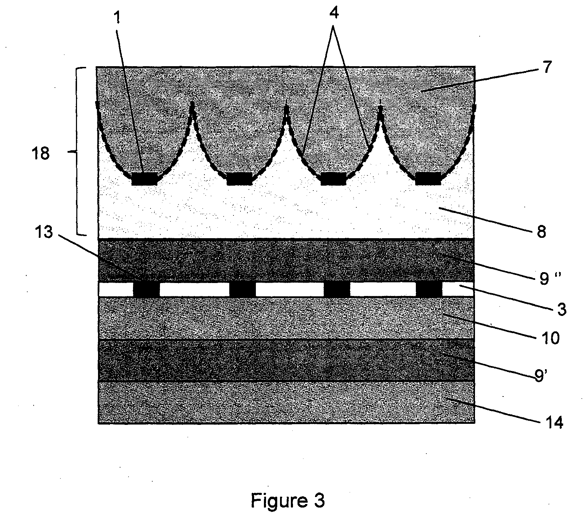

- la figure 3 montre schématiquement en coupe transversale la structure d'un dispositif d'affichage de type OLED selon l'invention.

Les figures ne sont pas à l'échelle, les épaisseurs relatives des composants du dispositif étant volontairement exagérées pour mieux faire apparaître sa structure.

### Description détaillée

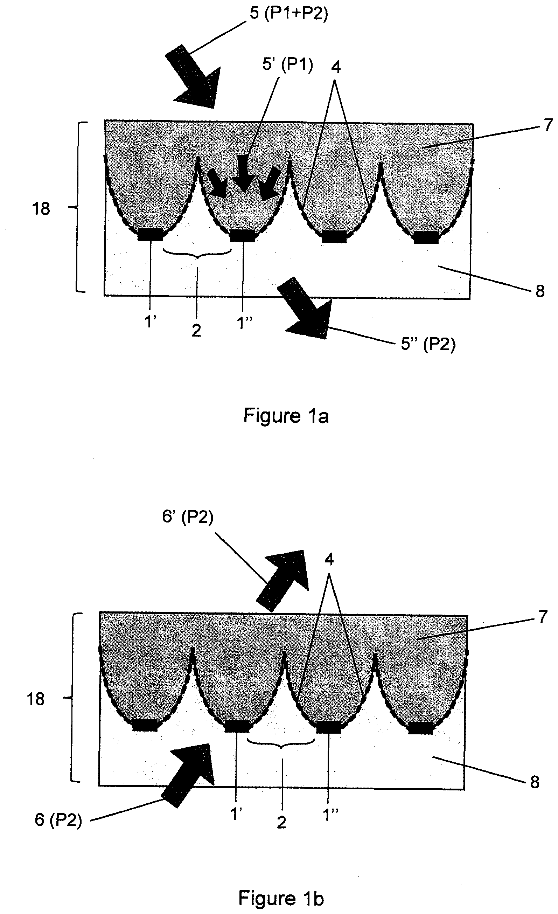

On se réfère aux figures 1a et 1b, qui représentent schématiquement des vues en coupe transversale d'une partie du dispositif d'affichage selon l'invention, appelé module photovoltaïque polarisant **18.** Ledit module photovoltaïque polarisant **18** comporte une pluralité de zones actives photovoltaïques **1**, deux zones actives photovoltaïques voisines **1'**,**1"** formant un orifice **2**, ainsi qu'une pluralité de polariseurs **4** semi-réfléchissants et de forme parabolique. Généralement constitués d'un ensemble de bandes métalliques de tailles contrôlées, lesdits polariseurs **4** sont agencés à l'interface entre deux couches de matériaux transparents **7**,**8** qui ont idéalement des indices de réfraction identiques ou très proches afin de limiter les phénomènes de réflexion totale de la lumière traversant cette interface.

Comme représenté sur la figure 1a, les polariseurs **4** réfléchissent une première composante polarisée linéaire **5'** de la lumière ambiante **5** émise par des sources de lumière naturelles ou artificielles extérieures au dispositif (donc non polarisée avant d'atteindre le dispositif) et transmettent à travers le module photovoltaïque polarisant 18 une deuxième composante polarisée linéaire **5"** orthogonale à la première. De par leur forme parabolique, les polariseurs **4** jouent le rôle de concentrateurs d'une partie de la lumière ambiante **5** par réflexions multiples de sa première composante polarisée linéaire **5'.** Ils sont positionnés par rapport aux zones actives photovoltaïques **1** de manière que ladite première composante polarisée linéaire **5'** de la lumière ambiante **5** soit dirigée par les concentrateurs de lumière **4** sur lesdites zones actives photovoltaïques **1.**

La figure 1b illustre le fonctionnement du module photovoltaïque polarisant **18** vis-à-vis de la lumière de l'image **6** émise par le dispositif d'affichage, généralement polarisée en sortie des dispositifs de type OLED et LCD émissifs ou réflectifs. On considère ici que les composants permettant l'affichage sont orientés de telle sorte que la lumière de l'image **6** corresponde à la deuxième composante polarisée linéaire **P2.** Dans le cas d'une interface parfaite, l'intégralité de la lumière polarisée de l'image **6** est transmise à travers les polariseurs semi-réfléchissants **4.** En pratique, des phénomènes de pertes par réflexion ou par absorption ayant lieu successivement dans les couches **8**,**4**,**7** limitent la quantité de lumière transmise **6'** à environ 90% de la quantité de lumière **6** en provenance de l'image. Par ailleurs, une partie de la lumière de l'image **6** est réfléchie ou absorbée en face arrière des zones actives photovoltaïques **1.** Toutefois, à production électrique constante, la fraction surfacique desdites zones actives photovoltaïques **1** est réduite par rapport à un dispositif standard sans concentrateurs de lumière **4**, ce qui permet d'augmenter la quantité totale de la lumière de l'image transmise **6'.**

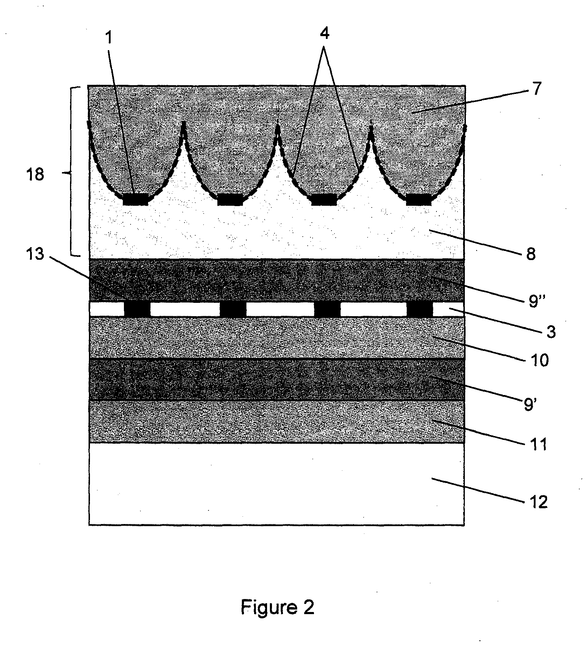

Le module photovoltaïque polarisant **18** peut être intégré dans un dispositif d'affichage soit en supplément des composants permettant l'affichage d'une image, soit en remplacement du dernier polariseur linéaire traversé par la lumière de l'image **6.** Les cas d'usage décrits dans les figures 2 à 4 font référence à trois dispositifs différents d'affichage dans lesquels le module photovoltaïque polarisant **18** vient en remplacement du dernier polariseur linéaire habituellement intégré dans de tels dispositifs.

La figure 2 schématise en coupe transversale la structure d'un dispositif d'affichage de type LCD émissif selon l'invention. Ledit dispositif est constitué entre autres d'un rétroéclairage **12** permettant de générer de la lumière via un éclairage à LED et d'un premier polariseur linéaire **11** qui polarise la lumière issue du rétroéclairage **12.** Le plan de polarisation de la lumière peut être modifié par un modulateur électro-optique **10** (à cristaux liquides dans le cas présent) piloté au moyen de deux électrodes transparentes déposées sur des substrats de verre **9'**,**9".** Les pixels **3** sont constitués en alternance de trois filtres colorés, typiquement de couleurs rouges, vertes et bleues et sont séparés par une matrice d'inter-pixels **13.** Le module photovoltaïque polarisant **18** joue le rôle du polariseur supérieur. Afin de maximiser la transmission et de limiter au maximum les phénomènes de Moiré connus de l'homme du métier, on choisira un pas du réseau de zones actives photovoltaïques **1** en fonction du pas de la matrice d'inter-pixels **13.**

La figure 3 schématise en coupe transversale la structure d'un dispositif d'affichage de type LCD réflectif selon l'invention. La composition d'un tel dispositif diffère de celui décrit à la figure 2 en ce que le rétroéclairage et le premier polariseur sont remplacés par un miroir **14.** La lumière de l'image **6** correspond à la lumière ambiante réfléchie par le miroir **14** et qui traverse les pixels **3.** Là encore, le polariseur disposé en standard au-dessus de l'électrode supérieure **9"** d'un tel dispositif est remplacé par le module photovoltaïque polarisant **18.**

Un exemple de réalisation concret est décrit par la suite. A partir d'un dispositif d'affichage contenant un réseau de pixels **3** de 150 µm de large séparés les uns des autres par une distance interpixels **13** de 30 µm, on approvisionne un module photovoltaïque formé d'un réseau de bandes actives photovoltaïques **1** de 10 µm de large, séparées par des orifices de 20 µm. Le substrat transparent structuré **8** a un indice de réfraction proche de 1.5. Les polariseurs **4** ont la forme de paraboles tronquées avec une surface d'entrée large de 30 µm et une hauteur comprise entre 20 et 40 µm. Dans le cas où la résine transparente de planarisation **7** a un indice de réfraction proche de 1.5, l'angle d'acceptance de la lumière ambiante incidente à la surface dudit dispositif est de 60°.

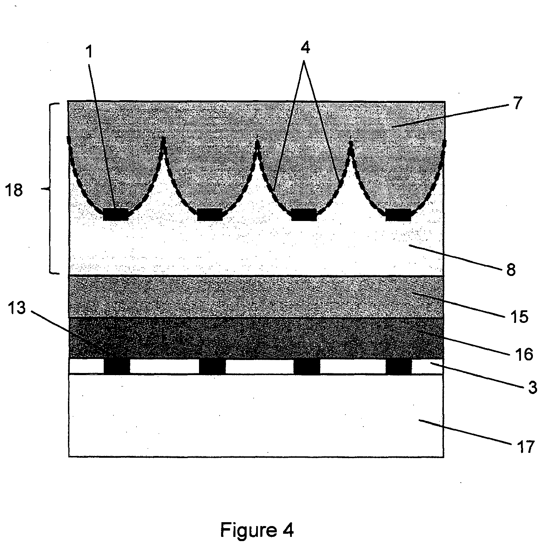

La figure 4 schématise en coupe transversale la structure d'un dispositif d'affichage de type OLED selon l'invention. Les pixels électroluminescents **3**, typiquement composés par l'alternance de trois matériaux organiques différents qui émettent dans le bleu, le vert et le rouge, sont déposés sur une dalle électronique **17** de pilotage desdits pixels électroluminescents **3**, puis encapsulés à l'aide d'un matériau transparent **16.** La couche d'encapsulation **16** permet d'accroître la stabilité des matériaux utilisés dans la fabrication des pixels **3**, en faisant notamment barrière à l'oxygène et à l'eau. La lumière de l'image **6** est directement émise par les pixels électroluminescents **3.** Dans un tel dispositif, le polariseur supérieur est généralement associé à une lame quart d'onde **15** qui permet d'éliminer la réflexion de la lumière ambiante. Ce polariseur est remplacé par le module photovoltaïque selon l'invention.

### Avantages de l'invention

Il résulte de ce qui précède que l'invention atteint les buts fixés. Elle décrit un dispositif d'affichage électronique comportant des polariseurs transflectifs aptes à concentrer efficacement une première composante de la lumière ambiante sur un réseau de zones actives photovoltaïques, tout en étant transparent à la deuxième polarisation de la lumière de l'image au niveau des orifices du module photovoltaïque. Ainsi, l'énergie de la première composante de la lumière ambiante, habituellement perdue par absorption dans les dispositifs d'affichage standards, est convertie en énergie électrique.

De plus, le dispositif objet de l'invention a l'avantage de produire de l'énergie indépendamment de l'état, clair ou sombre, de l'image.

Enfin, la fraction surfacique de zones actives photovoltaïques peut être optimisée afin de limiter les réflexions de la lumière ambiante du module photovoltaïque polarisant vers l'utilisateur.

**Liste des repères utilisés sur les figures :**

| | | | |
|---|---|---|---|
| 1 | Zone active photovoltaïque | 10 | Modulateur électro-optique |
| 2 | Orifice | 11 | Premier polariseur |
| 3 | Pixel | 12 | Rétro-éclairage |
| 4 | Polariseur semi-réfléchissant | 13 | Inter-pixel |
| 5 | Lumière ambiante | 14 | Miroir |
| 6 | Lumière de l'image | 15 | Lame quart d'onde |
| 7 | Première couche de matériau diélectrique transparent | 16 | Couche d'encapsulation |
| 8 | Deuxième couche de matériau diélectrique transparent | 17 | Dalle électronique de pilotage |
| 9 | Verre de protection et de pilotage du modulateur électro-optique | 18 | Module photovoltaïque polarisant |

## Revendications

1. Dispositif d'affichage pourvu d'un module photovoltaïque polarisant (18) comportant au moins :
(a) un polariseur (4);
(b) une pluralité de pixels (3) qui émettent ou transmettent une lumière appelée lumière de l'image (6) ;
(c) une pluralité de zones actives photovoltaïques (1),
ledit dispositif étant **caractérisé en ce que** deux zones actives photovoltaïques voisines (1',1") forment un orifice (2), lesdites zones actives photovoltaïques étant disposées entre les pixels (3) et le polariseur (4), et **en ce que** ledit polariseur (4) est constitué d'une ou plusieurs surfaces choisies parmi des surfaces planes, concaves ou convexes, le polariseur (4) présentant des formes paraboliques, coniques, pyramidales, tétraédriques, demi-cylindriques ou cylindro-paraboliques et étant agencé de manière à d'une part concentrer par réflexion une première composante polarisée linéaire (P1) de la lumière ambiante (5') sur lesdites zones actives photovoltaïques (1) et à d'autre part transmettre à travers ledit module photovoltaïque polarisant une deuxième composante polarisée linéaire (P2) de la lumière ambiante (5") ou de la lumière de l'image (6').

2. Dispositif d'affichage selon la revendication 1, **caractérisé en ce que** ledit polariseur (4) est composé d'un réseau de bandes réfléchissantes dont les largeurs et les distances qui les séparent sont avantageusement inférieures à 400 nanomètres.

3. Dispositif d'affichage selon l'une quelconque des revendications précédentes, **caractérisé en ce que** lesdites zones actives photovoltaïques (1) sont positionnées au voisinage du plan de concentration maximum dudit polariseur (4).

4. Dispositif d'affichage selon l'une quelconque des revendications précédentes, **caractérisé en ce que** la pluralité de pixels (3) sont séparés les uns des autres par une matrice interpixels (13) et **en ce que** lesdites zones actives photovoltaïques (1) sont alignées avec la matrice interpixels (13).

5. Dispositif d'affichage selon l'une quelconque des revendications précédentes, **caractérisé en ce que** lesdites zones actives photovoltaïques (1) et ledit polariseur (4) sont organisés en un réseau continu ou discontinu de motifs élémentaires, délimitant tous types de formes, en particulier des formes courbes, par exemple circulaires, des formes planes, par exemple polygonales, prismatiques ou hexagonales.

6. Dispositif d'affichage selon l'une quelconque des revendications précédentes, **caractérisé en ce que** lesdits pixels (3) sont constitués de modulateurs électro-optiques, éventuellement associés à des filtres colorés, ou de matériaux électroluminescents.

7. Dispositif d'affichage selon l'une quelconque des revendications précédentes, **caractérisé en ce que** ladite lumière de l'image correspond à une partie de la lumière ambiante réfléchie, totalement ou partiellement, dans le dispositif et/ou à une partie de la lumière émise par le dispositif.

8. Dispositif d'affichage selon l'une quelconque des revendications précédentes, **caractérisé en ce qu'**il comporte en outre un ou plusieurs autres polariseurs et/ou une lame quart d'onde servant à polariser la lumière de l'image.

9. Dispositif d'affichage selon l'une quelconque des revendications précédentes, **caractérisé en ce qu'**il comporte en outre une surface fonctionnelle, par exemple anti-reflet, anti-UV ou de détection tactile.

10. Procédé de fabrication d'un module photovoltaïque polarisant pour un dispositif d'affichage selon l'une quelconque des revendications précédentes, ledit module photovoltaïque polarisant comportant un polariseur (4) et des zones actives photovoltaïques (1), **caractérisé en ce qu'**il comporte successivement des étapes consistant à:
(a) approvisionner un module photovoltaïque polarisant semi-transparent composé d'une pluralité de zones actives photovoltaïques (1) et d'une pluralité d'orifices (2), lesdites zones actives photovoltaïques (1) étant constituées d'une pluralité de couches minces déposées sur un substrat transparent (8) ;
(b) déposer une première couche de résine transparente (8) puis structurer ladite résine (8) de manière à former un polariseur de forme parabolique, conique, pyramidale, tétraédrique, demi-cylindrique ou cylindro-parabolique;
(c) déposer une couche conforme d'un matériau réfléchissant sur la face structurée de ladite résine (8) ;
(d) graver la couche réfléchissante sur toute sa surface sous la forme de bandes et au niveau des sommets du polariseur (4), les bandes étant agencées de manière à d'une part concentrer par réflexion une première composante polarisée linéaire (P1) de la lumière incidente sur lesdites zones actives photovoltaïques (1) et à d'autre part transmettre à travers ledit module photovoltaïque polarisant une deuxième composante polarisée linéaire (P2) orthogonale à la première.
(e) déposer une seconde couche de résine transparente (7) de planarisation.

11. Appareil électronique, fixe ou portable, rigide ou flexible, **caractérisé en ce qu'**il comprend un dispositif d'affichage selon l'une quelconque des revendications 1 à 9.

## Patentansprüche

1. Anzeigevorrichtung, die mit einem polarisierenden Photovoltaikmodul (18) versehen ist, umfassend mindestens:
(a) einen Polarisator (4);
(b) eine Vielzahl von Pixeln (3), die ein Licht, Licht des Bildes (6) genannt, emittieren oder übertragen;
(c) eine Vielzahl von aktiven Photovoltaikbereichen (1),
wobei die Vorrichtung **dadurch gekennzeichnet ist, dass** zwei benachbarte aktive Photovoltaikbereiche (1',1") eine Öffnung (2) bilden, wobei die aktiven Photovoltaikbereiche zwischen den Pixeln (3) und dem Polarisator (4) angeordnet sind, und dadurch, dass der Polarisator (4) aus einer oder mehreren Oberflächen besteht, die unter ebenen, konkaven oder konvexen Oberflächen ausgewählt sind, wobei der Polarisator (4) parabolische, konische, pyramidale, tetraedrische, halbzylindrische oder zylinderparabolische Formen aufweist und so gestaltet ist, dass er zum einen durch Reflexion eine erste polarisierte lineare Komponente (P1) des Umgebungslichts (5') auf die aktiven Photovoltaikbereiche (1) konzentriert und zum anderen durch das polarisierende Photovoltaikmodul hindurch eine zweite polarisierte lineare Komponente (P2) des Umgebungslichts (5") oder des Lichts des Bildes (6') überträgt.

2. Anzeigevorrichtung nach Anspruch 1, **dadurch gekennzeichnet, dass** der Polarisator (4) aus einem Gitter reflektierender Streifen besteht, deren Breiten und deren sie trennende Abstände vorteilhafterweise kleiner als 400 Nanometer sind.

3. Anzeigevorrichtung nach einem der vorhergehenden Ansprüche, **dadurch gekennzeichnet, dass** die aktiven Photovoltaikbereiche (1) in der Nähe der Konzentrationsmaximumebene des Polarisators (4) angeordnet sind.

4. Anzeigevorrichtung nach einem der vorhergehenden Ansprüche, **dadurch gekennzeichnet, dass** die Vielzahl von Pixeln (3) voneinander durch eine Inter-Pixel-Matrix (13) getrennt sind, und dadurch, dass die aktiven Photovoltaikbereiche (1) auf die Inter-Pixel-Matrix (13) ausgerichtet sind.

5. Anzeigevorrichtung nach einem der vorhergehenden Ansprüche, **dadurch gekennzeichnet, dass** die aktiven Photovoltaikbereiche (1) und der Polarisator (4) in einem kontinuierlichen oder diskontinuierlichen Gitter aus elementaren Mustern organisiert sind, die alle Arten von Formen begrenzen, insbesondere gekrümmte Formen, zum Beispiel kreisförmige, ebene Formen, zum Beispiel polygonale, prismatische oder hexagonale.

6. Anzeigevorrichtung nach einem der vorhergehenden Ansprüche, **dadurch gekennzeichnet, dass** die Pixel (3) aus elektro-optischen Modulatoren, die gegebenenfalls Farbfiltern zugeordnet sind, oder aus elektrolumineszenten Materialien bestehen.

7. Anzeigevorrichtung nach einem der vorhergehenden Ansprüche, **dadurch gekennzeichnet, dass** das Licht des Bildes einem Teil des vollständig oder teilweise in der Vorrichtung reflektierten Umgebungslichts und/oder einem Teil des von der Vorrichtung emittierten Lichts entspricht.

8. Anzeigevorrichtung nach einem der vorhergehenden Ansprüche, **dadurch gekennzeichnet, dass** sie ferner einen oder mehrere weitere Polarisatoren und/oder ein Viertelwellenplättchen aufweist, die dazu dienen, das Licht des Bildes zu polarisieren.

9. Anzeigevorrichtung nach einem der vorhergehenden Ansprüche, **dadurch gekennzeichnet, dass** sie ferner eine Funktionsoberfläche aufweist, zum Beispiel eine Entspiegelungs-, UV-Schutz- oder berührungsempfindliche Oberfläche.

10. Verfahren zur Herstellung eines polarisierenden Photovoltaikmoduls für eine Anzeigevorrichtung nach einem der vorhergehenden Ansprüche, wobei das polarisierende Photovoltaikmodul einen Polarisator (4) und aktive Photovoltaikbereiche (1) umfasst, **dadurch gekennzeichnet, dass** es nacheinander Schritte umfasst, die in Folgenden bestehen:
(a) Beschaffen eines semitransparenten polarisierenden Photovoltaikmoduls, das aus einer Vielzahl von aktiven Photovoltaikbereichen (1) und einer Vielzahl von Öffnungen (2) besteht, wobei die aktiven Photovoltaikbereiche (1) aus einer Vielzahl dünner Schichten bestehen, die auf ein transparentes Substrat (8) aufgebracht sind;
(b) Aufbringen einer ersten Schicht aus transparentem Harz (8), dann Strukturieren des Harzes (8) derart, dass ein parabolischer, konischer, pyramidaler, tetraedrischer, halbzylindrischer oder zylinderparabolischer Polarisator gebildet wird;
(c) Aufbringen einer konformen Schicht eines reflektierenden Materials auf die strukturierte Seite des Harzes (8);
(d) Ätzen der reflektierenden Schicht auf ihrer gesamten Oberfläche in Form von Streifen und an den Scheitelpunkten des Polarisators (4), wobei die Streifen so gestaltet sind, dass zum einen durch Reflexion eine erste polarisierte lineare Komponente (P1) des einfallenden Lichts auf die aktiven Photovoltaikbereiche (1) konzentriert wird und zum anderen durch das polarisierende Photovoltaikmodul hindurch eine zweite polarisierte lineare Komponente (P2), die senkrecht zur ersten verläuft, übertragen wird;
(e) Aufbringen einer zweiten transparenten Harzschicht (7) zur Glättung.

11. Stationäres oder portables, starres oder flexibles elektronisches Gerät, **dadurch gekennzeichnet, dass** es eine Anzeigevorrichtung nach einem der Ansprüche 1 bis 9 umfasst.

## Claims

1. Display device provided with a polarizing photovoltaic module (18) including at least:
(a) one polarizer (4);
(b) a plurality of pixels (3) which emit or transmit a light referred to as image light (6) ;
(c) a plurality of photovoltaic active zones (1), said device being **characterized in that** two neighboring photovoltaic active zones (1', 1") form an opening (2), said photovoltaic active zones being positioned between the pixels (3) and the polarizers (4), and **in that** said polarizer (4) consists of one or more surfaces chosen from among planar, concave or convex surfaces, the polarizer (4) being parabolic, conical, pyramidal, tetrahedral, semicylindrical or cylindro-parabolic in shape, and being arranged so as both to concentrate, by reflection, a first linearly polarized component (P1) of the ambient light (5') onto said photovoltaic active zones (1) and to transmit, through said polarizing photovoltaic module, a second linearly polarized component (P2) of the ambient light (5") or of the image light (6').

2. Display device according to Claim 1, **characterized in that** said polarizer (4) is composed of an array of reflective strips, the widths of which and the distances separating them are advantageously less than 400 nanometers.

3. Display device according to either of the preceding claims, **characterized in that** said photovoltaic active zones (1) are positioned in the vicinity of the plane of maximum concentration of said polarizer (4).

4. Display device according to any one of the preceding claims, **characterized in that** the plurality of pixels (3) are separated from one another by an inter-pixel matrix (13) and **in that** said photovoltaic active zones (1) are aligned with the inter-pixel matrix (13).

5. Display device according to any one of the preceding claims, **characterized in that** said photovoltaic active zones (1) and said polarizer (4) are organized into a continuous or discontinuous array of elementary patterns, defining any type of shape, in particular curved shapes, for example circular shapes, and/or planar shapes, for example polygonal, prismatic or hexagonal shapes.

6. Display device according to any one of the preceding claims, **characterized in that** said pixels (3) consist of electro-optical modulators, optionally combined with colour filters, or of electroluminescent materials.

7. Display device according to any one of the preceding claims, **characterized in that** said image light corresponds to a portion of the ambient light that is fully or partially reflected in the device and/or a portion of the light emitted by the device.

8. Display device according to any one of the preceding claims, **characterized in that** it additionally includes one or more other polarizers and/or a quarter-wave plate being used to pulverize the image light.

9. Display device according to any one of the preceding claims, **characterized in that** it additionally includes a functional surface, for example an antireflective, anti-UV or touch-sensitive surface.

10. Method for manufacturing a polarizing photovoltaic module for a display device according to any one of the preceding claims, said pulverizing photovoltaic module including a polarizer (4) and photovoltaic active zones (1), **characterized in that** it successively includes steps consisting of:
a. providing a semitransparent polarizing photovoltaic module composed of a plurality of photovoltaic active zones (1) and a plurality of openings (2), said photovoltaic active zones (1) consisting of a plurality of thin films deposited on a transparent substrate (8);
b. depositing a first transparent resin layer (8) then structuring said resin (8) so as to form a polarizer which is parabolic, conical, pyramidal, tetrahedral, semicylindrical or cylindro-parabolic in shape;
c. depositing a conformal layer of a reflective material on the structured face of said resin (8) ;
d. etching the entire surface of the reflective layer in the form of strips and etching the surface at the tops of the polarizer (4), the strips being arranged so as both to concentrate, by reflection, a first linearly polarized component (P1) of the incident light onto said photovoltaic active zones (1) and to transmit, through said polarizing photovoltaice module, a second linearly polarized component (P2) which is orthogonal to the first;
e. depositing a second, planarizing layer of transparent resin (7).

11. Fixed or portable, rigid or flexible electronic unit, **characterized in that** it comprises a display device according to any one of Claims 1 to 9.
